(19) Europäisches Patentamt European Patent Office Office européen des brevets

(11) **EP 3 575 670 B1**

(12) **EUROPEAN PATENT SPECIFICATION**

(45) Date of publication and mention
of the grant of the patent:
**10.08.2022 Bulletin 2022/32**

(21) Application number: **18781536.0**

(22) Date of filing: **04.04.2018**

(51) International Patent Classification (IPC):
*F21K 9/64* (2016.01)       *F21V 23/00* (2015.01)
*F21Y 115/10* (2016.01)      *H01L 33/50* (2010.01)
*F21K 9/00* (2016.01)

(52) Cooperative Patent Classification (CPC):
**F21K 9/64; H01L 33/504**

(86) International application number:
**PCT/CN2018/081969**

(87) International publication number:
**WO 2018/184575 (11.10.2018 Gazette 2018/41)**

(54) **LIGHT SOURCE MODULE, AND ILLUMINATION DEVICE COMPRISING LIGHT SOURCE MODULE**

LICHTQUELLENMODUL UND BELEUCHTUNGSVORRICHTUNG MIT LICHTQUELLENMODUL

MODULE SOURCE DE LUMIÈRE ET DISPOSITIF D'ÉCLAIRAGE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.04.2017 CN 201720356384 U**
**07.04.2017 CN 201710222531**

(43) Date of publication of application:
**04.12.2019 Bulletin 2019/49**

(73) Proprietors:
• **Suzhou Opple Lighting Co., Ltd.**
**Suzhou, Jiangsu 215211 (CN)**
• **Opple Lighting Co., Ltd.**
**Shanghai 201201 (CN)**

(72) Inventors:
• **ZHOU, Zhixian**
**Suzhou, Jiangsu 215211 (CN)**
• **QIANG, Jie**
**Suzhou, Jiangsu 215211 (CN)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(56) References cited:
**EP-A1- 2 432 037       EP-A2- 2 642 519**
**WO-A1-2012/046288    CN-A- 105 737 090**
**CN-A- 105 737 091    CN-A- 106 931 332**
**CN-U- 205 640 712    CN-U- 206 708 776**
**US-A1- 2012 319 565    US-A1- 2015 049 459**
**US-A1- 2016 290 573    US-A1- 2016 308 098**
**US-B2- 8 643 038**

**Description**

TECHNICAL FIELD

The present invention relates to a light source module and an illuminating device including the light source module.

BACKGROUND

With the arrival and development of the third lighting technology revolution, light-emitting diode (LED) lighting devices are widely used, and users have higher and higher requirements on a light quality thereof. For a long time, a research on the light quality has focused only on color rendering index (CRI) and cannot reach a deeper level.

Several light source modules are known from EP 2 642 519 A2, US 2015/049459 A1, EP 2 432 037 A1 and US 8 643 038 B2. However, it has been found by the lighting industry that, a color rendering evaluation of LED light sources by CRI Ra is not consistent with a visual experience, and for environments with higher color saturation, CRI values usually are not consistent with the users' visual experience, either. It is also pointed out in a report of CIE (International Commission on Illumination) in 2007 that the CRI Ra is not suitable for evaluation of color rendering property of a LED light source. Organizations such as CIE and IES (Illuminating Engineering Society of North America) have proposed GAI, CQS and other methods for evaluating color rendering capacity of a light source, in succession, so as to supplement the deficiency of CRI. IES officially released a new method for evaluating the color rendering capacity of a light source, i.e., IES TM-30-15 IES Method for Evaluating Light Source Color Rendition, on May 18, 2015. Chip packaging manufacturers and chip application manufacturers have also offered products with higher GAI index, higher CQS index, or better TM30-15 index, in addition to the CRI index, one after another. However, a relationship between a specific index and a visual representation of the product still needs to be verified.

SUMMARY

An objective of the present invention is to seek for a LED light source with higher vividness, according to indexes such as CRI, GAI, CQS and TM30-15, so as to solve the above problem.

In order to achieve the objective above, the technical solution as adopted by the present invention is to provide a light source module as defined in independent claim 1. Further preferred embodiments of the present invention are defined in the dependent claims. The light source module according to the present invention includes:

> a blue light generating unit configured to emit blue light;
> a green light generating unit configured to emit green light; and
> a red light generating unit configured to emit red light, wherein
> for the blue light emitted by the blue light generating unit, a peak wavelength is within the range of 430nm to 470nm, and half the value of the full width at half maximum of the emission spectrum is within the range of 15nm to 35nm;
> for the red light emitted by the red light generating unit, a peak wavelength is within the range of 620nm to 660nm, and half the value of the full width at half maximum of the emission spectrum is within the range of 70nm to 105nm;
> wherein a peak intensity of the blue light is 40% to 60% of a peak intensity of the red light;
> for the green emitted by the green light generating unit, within a spectrum range of 510nm to 580nm, by taking 5nm as a measuring interval, a relative difference of neighboring spectral intensities within a wavelength width of 5nm is less than 15%; and
> irradiation light emitted by the light source module satisfies such a condition in the CIE1931 color coordinate system that, a horizontal coordinate X is within the range of 0.410 to 0.450, and a longitudinal coordinate Y is within the range of 0.375 to 0.415. The term "half-width" used throughout the present description refers to half the value of the full width at half maximum.

Further, light emitted by the light source module further satisfies the condition that: given a same wavelength, a difference $A(\lambda)$ between a change rate $A1(\lambda)$ of spectral intensities for neighboring wavelengths of a luminescent spectrum of the light source module, and a change rate $A2(\lambda)$ of spectral intensities for neighboring wavelengths of a heat dissipation spectrum of Planck blackbody radiation with a color temperature as same as that of the light source module is within the range of [-3.0, 3.0].

Further, the $A(\lambda)$ is within the range of [-1.5, 1.5].

Further, the half-width of the emission spectrum of the red light is within the range of 70nm to 85nm or the range of 95nm to 105nm.

Further, the blue light generating unit is a blue LED chip.

Further, the green light generating unit contains a green fluorophor which absorbs light emitted by the blue light generating unit and emits green light through wavelength conversion.

Further, the red light generating unit contains a red fluorophor which absorbs light emitted by the blue light generating unit and emits red light through wavelength conversion.

Further, the blue light generating unit, the green light generating unit and the red light generating unit are integrally packaged, wherein the blue light generating unit is a blue LED, the green light generating unit is a green fluorophor which absorbs light emitted by the blue light generating unit and emits green light through wavelength conversion, and the red light generating unit is a red fluorophor which absorbs light emitted by the blue light generating unit and emits red light through wavelength conversion.

Further, the green fluorophor is of aluminate system or silicate system or nitride system or oxynitride system or a combination of any two thereof.

Further, the red fluorophor is of nitride system or silicate system or a combination thereof.

Further, the horizontal coordinate X is within the range of 0.420 to 0.440, and the longitudinal coordinate Y is within the range of 0.385 to 0.405.

Further, the horizontal coordinate X is within the range of 0.425 to 0.435, and the longitudinal coordinate Y is within the range of 0.390 to 0.400.

Further, a color temperature of the light emitted by the light source module is within the range of 2500K to 3600K.

Further, a color rendering parameter CRI of the light emitted by the light source module is greater than 90.

Further, a color rendering index Rf of the light emitted by the light source module is greater than 90.

Further, a color rendering index R9 of the light emitted by the light source module is greater than 70.

Further, a gamut index Rg of the light emitted by the light source module is greater than 100.

The present invention further provides an illuminating device, including:

the light source module described above; and
a power supply module connected to the light source module and configured to provide the light source module with a working power.

Further, the illuminating device further includes a controller, the controller is connected to the light source module and configured to adjust the irradiation light emitted by the light source module

The light source module provided by the present invention has a specific spectral distribution, in which not only an evaluation of illuminating effect under color theory but also an influence of a spectrum on an actual illuminating effect is considered, and meanwhile an impact of a luminous material on the spectrum is also taken into account. Thus, a light source highly preferred by illuminated objects with high vividness, high color rendering index and high color gamut index can be obtained, and the light source can achieve an effect similar to a ceramic metal halide lamp.

BRIEF DESCRIPTION OF THE DRAWINGS

The drawings described herein are intended to provide a further understanding of the present invention and constitute one part thereof. The illustrative embodiments of the present invention and the description thereof are used for explaining the present invention and do not constitute any inappropriate limitation of the present invention other than as defined in the appended claims.

FIG. 1 is a structurally schematic diagram illustrating an illuminating device of the present invention;
FIG. 2 is a schematic diagram illustrating the relative spectral energy distribution of Embodiment 1 of the present invention;
FIG. 3 is a schematic diagram illustrating the distribution of A (λ) in Embodiment 1 of the present invention;
FIG. 4 is a schematic diagram illustrating the relative spectral energy distribution of Embodiment 2 of the present invention
FIG. 5 is a schematic diagram illustrating the distribution of A (λ) in Embodiment 2 of the present invention;
FIG. 6 is a schematic diagram illustrating the relative spectral energy distribution of Embodiment 3 of the present invention
FIG. 7 is a schematic diagram illustrating the distribution of A (λ) in Embodiment 3 of the present invention;
FIG. 8 is a schematic diagram illustrating the relative spectral energy distribution of Embodiment 4 of the present invention
FIG. 9 is a schematic diagram illustrating the distribution of A (λ) in Embodiment 4 of the present invention;
FIG. 10 is a schematic diagram illustrating the relative spectral energy distribution of Embodiment 5 of the present invention
FIG. 11 is a schematic diagram illustrating the distribution of A (λ) in Embodiment 5 of the present invention;

FIG.12 is a schematic diagram illustrating CIE1931 color coordinate of Embodiments 1 to 5 of the present invention; and

FIG.13 is a structurally schematic diagram illustrating a light source module according to the present invention.

## DETAILED DESCRIPTION

A light source module and an illuminating device provided by the present invention will be described further below in connection with accompanying drawings and particular embodiments.

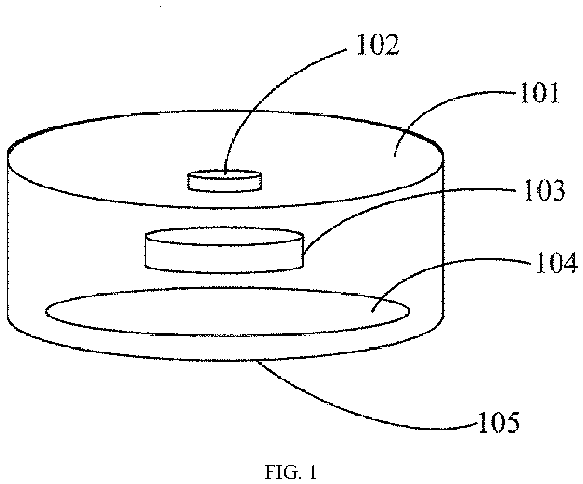

The light source module provided by the present invention is a warm white light source with a color temperature in the range from 2500K to 3600K, and can be applied in a lighting luminaire 101 illustrated in FIG. 1 for daily lighting. The lighting luminaire 101 includes a power driver (not illustrated), a controller 102, a heat dissipation device 103, a lighting module 104 and a lampshade 105, etc. The controller may be configured to adjust a light color and a light intensity of the lighting module 104, and the lampshade 105 may be replaced by other optical elements in other embodiments, such as a lens, a diffusion element, a photoconductor or the like, in accordance with the design of the luminaire. The heat dissipation device may not be included in the lighting luminaire. The light source module 104 includes a blue light generating unit for outputting a blue light component, a green light generating unit for outputting a yellowish-green light component and a red light generating unit for outputting a red light component.

These light generating units for different colors of light in the light source module 104 may be LED chips or fluorescent materials capable of converting a wavelength of light, or a combination of LED chips and fluorescent materials. Depending on the difference in color of the emitted light, fluorescent powders of different systems may be adopted as the fluorescent material. For the blue light generating unit, a monochromatic LED chip may be adopted, and the monochromatic LED chip used herein refers to a LED chip which gives out light by directly exciting a semiconductor material and has no fluorophor. In addition, it is also possible for the blue light generating unit to adopt a mode of a LED chip in cooperation with a fluorophor, that is, the blue light generating unit contains a blue fluorophor which absorbs light emitted by a semiconductor luminous element (LED chip) and emits blue light through wavelength conversion; and the semiconductor luminous element used herein may be a monochromatic LED chip which emits ultraviolet light. The red light generating unit is similar to the blue light generating unit, and may adopt a monochromatic LED chip; moreover, in a preferred embodiment, the red light generating unit contains a red fluorophor which absorbs light emitted by a semiconductor luminous element and emits red light through wavelength conversion. And the green light generating unit includes a green fluorophor which absorbs light emitted by a semiconductor luminous element and emits green light through wavelength conversion. The type of the green fluorophor includes aluminate system such as YAG, Ga-YAG, Lu-AG, TbAG and so on, silicate system, nitride system, and nitrogen oxide system. The green light generating unit may be excited by a single type of fluorophor to produce green light, and may also be excited by a combination of two types of fluorophors or more, or even a combination of fluorophors with a variety of peak wavelengths. When it's the case of a combination of several types of fluorophors, these fluorophors are not confined in one element or component; for example, they may be different green fluorophors in two white LEDs, and a spectral intensity in the range from 510nm to 580nm as required can be obtained by superimposing spectrums produced by these fluorophors. This combination of fluorophors is not limited to be used in the green light generating unit, and when the blue light generating unit and the red light generating unit contain fluorophors, they may also use fluorophors with various compositions, and these fluorophors may be distributed in different elements or components. It should be explained that, the "red light generating unit" and the "green light generating unit" used herein are merely an expression for describing the present invention, and a red fluorophor with a wider emission bandwidth always has part of its energy in a green light domain; in this case, it should be understood that the red fluorophor partly realizes a function of the red light generating unit and partly contributes to green light emission, that is, the green light generating unit is composed of a green fluorophor and a red fluorophor.

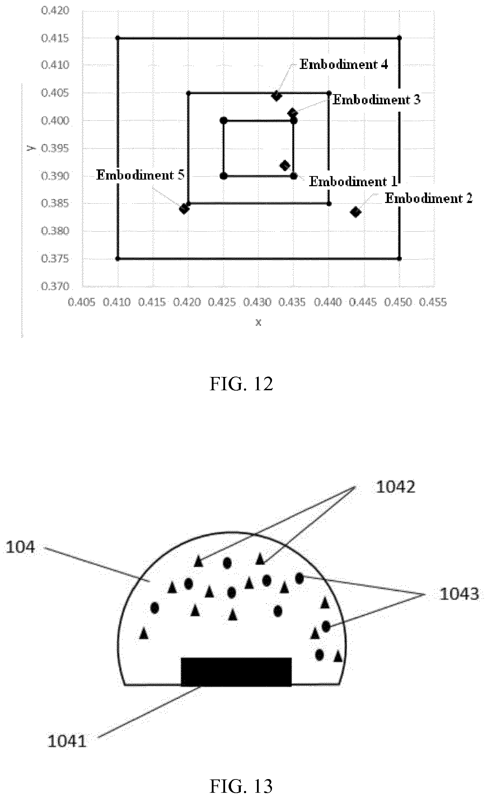

The design scheme of the light source module 104 is finally determined by designing a specific proportion for different generating units, in combination with data of visual experiments. As illustrated in FIG. 13 , the blue light generating unit 1041 is a blue light LED, the green light generating unit 1042 is a green fluorescent powder, the red light generating unit 1043 is a red fluorescent powder, and the light source module 104 is a white light LED chip; the white light LED chip is packaged and forms a white spectrum with a color temperature in the range between 2500K and 3600K, and both the color rendering parameters CRI, R9, Rf and the color gamut index Rg and the like of the spectrum have higher values. Corresponding to the blue light generating unit, the red light generating unit and the green light generating unit, a spectral distribution of the light source module 104 has relatively obvious, two spectral emission peaks. For the first emission peak, its wavelength resides between 430nm and 470nm, it is generated by the blue light generating unit, and a half-width of its emission spectrum is in the range of 15nm to 35nm. A luminous zone formed by green light generated by the green light generating unit is distributed over a range of 510nm to 580nm, and the spectral distribution of green light is gentle. Taking 5nm as a measuring interval, a relative difference between neighboring spectral intensities within a wavelength width of 5nm is less than 15%. For the second emission peak, its wavelength resides between 620nm and 660nm, it is produced by red fluorescent powders excited by blue light, and a spectral intensity of the second peak is the maximum value in the whole spectrum. The peak intensity of blue light, that is, the first peak, is 40% to 60% of the peak intensity of red light, that is, the second peak. A half-width (i.e. half the value of the full width at half maximum) of an emission spectrum of red fluorescent powders is in the range of 70nm to 105nm, and in a specific embodiment, the half-width of most of the red fluorophors in the present invention falls within following two ranges: 70nm to 85nm, and 95nm to 105nm. As a result, values in these two ranges are more preferred.

As a feature of the present invention, under the same wavelength, a change rate of spectral intensity for neighboring wavelengths of a luminescent spectrum of the light source module 104 is indicated by A1($\lambda$), and a change rate of spectral intensity for neighboring wavelengths of a heat radiation spectrum of Planck blackbody radiation having the same color temperature with the light source module 104 is indicted by A2($\lambda$). A difference A($\lambda$) between A1($\lambda$) and A2($\lambda$) falls within the region of [-3.0, 3.0], that is, $-3.0 \leq A1(\lambda)-A2(\lambda) \leq 3.0$, and in a more preferred embodiment, $-1.5 \leq A1(\lambda)-A2(\lambda) \leq 1.5$.

The term "neighboring" as used herein takes 5nm as a computation interval, that is, when the change rate of spectral intensity for neighboring wavelengths is calculated, an interval of 5nm is taken into account, and particular operational formulas for A1($\lambda$) and A2($\lambda$) are as follows:

$$A1(\lambda) = \left[ P(\lambda) * \frac{100}{\sum (P(\lambda)*V(\lambda))} - P(\lambda-1) * \frac{100}{\sum (P(\lambda)*V(\lambda))} \right];$$

$$A2(\lambda) = \left[ R(\lambda) * \frac{100}{\sum (R(\lambda)*V(\lambda))} - R(\lambda-1) * \frac{100}{\sum (R(\lambda)*V(\lambda))} \right],$$

where P($\lambda$) is the luminescent spectrum of the light source module, R($\lambda$) is the luminescent spectrum of the heat radiator having the same color temperature with the light source module in the visible light range, and V($\lambda$) is a luminous efficiency function of a photopic vision spectrum.

The heat radiation spectrum is calculated according to the Planck blackbody radiation formula, and the computational formulas are as follows:

$$R(\lambda)=A/(\exp(B)-1);$$

$$A=(2*h*c*c)/ \lambda^{\wedge 5};$$

$$B=(h*c)/(\lambda*k*CCT);$$

CCT is the color temperature value of the spectrum, h is the Planck constant which is 6.626E-34 joule*second, c is the speed of light, which is 3.000E8 m/s, and k is the Boltzmann constant coefficient, which is 1.38065E-23 kg*s$^{-2}$*K$^{-1}$.

A color coordinate scope of the light color of the light source module 104 is that, x is in the range between 0.410 and 0.450, and y is in the range between 0.375 and 0.415 (x=0.410~0.450, y=0.375~0.415); a preferred color coordinate scope is that, x is in the range between 0.420 and 0.440, and y is in the range between 0.385 and 0.405 (x=0.420~0.440, y=0.385~0.405); and the most preferred scope is that, x is in the range between 0.425 and 0.435, and y is in the range between 0.390 and 0.400 (x=0.425~0.435, y=0.390~0.400). The color rendering parameters CRI, Rf of this spectrum each are no less than 90.0; R9 is no less than 70.0; and the gamut index Rg is no less than 100.0.

Several preferred embodiments of the light source module 104 will be introduced below.

Embodiment 1

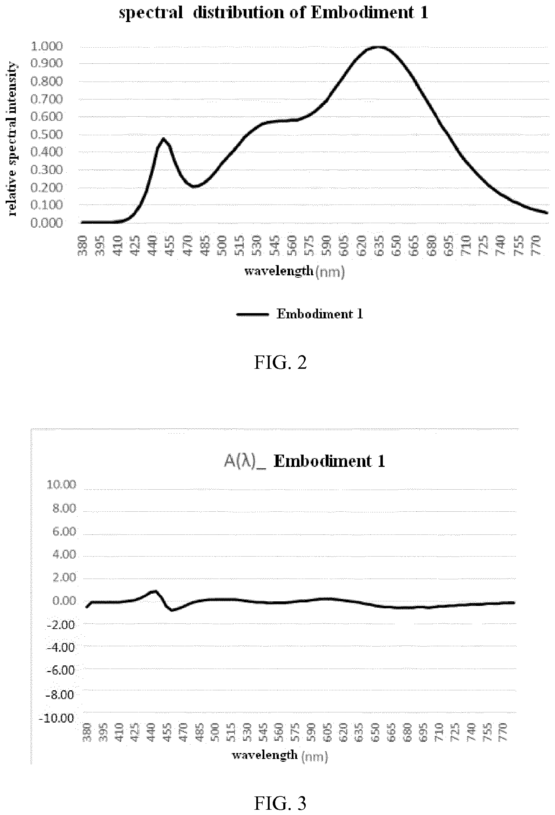

In the following, Embodiment 1 is described, which does not fall under the definition of independent claim 1. The light source module 104 is provided with: a blue LED chip with a peak wavelength of 450 $\pm$5nm which is used as a blue light generating unit, a red fluorophor capable of converting part of blue light emitted by the blue light generating unit into red light which is used as a red light generating unit, and a green fluorophor capable of converting part of blue light emitted by the blue light generating unit into green light which is used as a green light generating unit. In the present embodiment, the blue light LED chip is used not only as the blue light generating unit, but also as an excitation light source for the red light generating unit and the green light generating unit. FIG. 2 is a schematic diagram illustrating the relative spectral energy distribution of Embodiment 1. A luminescent peak for forming a first peak in the figure by energy of blue light emitted by the blue light LED chip is at a wavelength of 450nm, and a half-width FWHM is 21.8 ±5nm (21.8 is a measured value of one light source module, and because a slight divergence may be existed in actually measured values of the half-width for every light source module of the same batch in actual production, there will be a positive/negative range, and the values below follow the same pattern). The green fluorophor converts part of blue light emitted by the blue LED chip into green light. Within the range of 510nm to 580nm, by taking 5nm as a measuring interval, the maximum value of a relative percentile difference between two neighboring spectral intensities with the same wavelength broadband is 0.11. The red fluorophor (a nitride fluorescent powder for this embodiment) converts part of blue light emitted by the blue LED chip into red light, which forms a second peak in FIG. 2. For the second peak, a luminescent peak is at a wavelength of 635nm, and a half-width FWHM is 83.2±5nm. A peak intensity of the first peak is about 47.6% of that of the second peak. The distribution of $A(\lambda)$ in Embodiment 1 is illustrated in FIG. 3, wherein $A(\lambda)=A1(\lambda)-A2(\lambda)$, and as can be seen from the figure, a value of $A(\lambda)$ is in the range between -0.78 and 0.85. A color coordinate of Embodiment 1 is x=0.4337 and y=0.3919 (x=0.4337, y=0. 0.3919), a color temperature is 2964K, color rendering indexes CRI=95.6, R9=95.8, Rf=93.4, and a gamut index Rg=105.6.

Embodiment 2

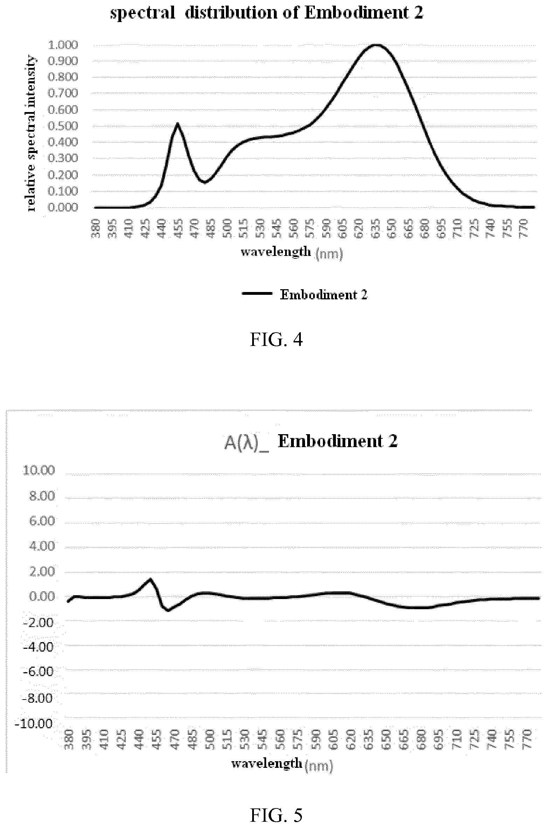

In the following, Embodiment 2 is described, which does not fall under the definition of independent claim 1. The light source module 104 is provided with: a blue LED chip with a peak wavelength of 455 ±5nm which is used as a blue light generating unit, a red fluorophor capable of converting part of blue light emitted by the blue light generating unit into red light which is used as a red light generating unit, and a green fluorophor capable of converting part of blue light emitted by the blue light generating unit into green light which is used as a green light generating unit. In the present embodiment, the blue light LED chip is used not only as the blue light generating unit, but also as an excitation light source for the red light generating unit and the green light generating unit. FIG. 4 is a schematic diagram illustrating the relative spectral energy distribution of Embodiment 2. A luminescent peak for forming a first peak in the figure by energy of blue light emitted by the blue light LED chip is at a wavelength of 455nm, and a half-width FWHM is 22.3±5nm. The green fluorophor (Ga-YAG in aluminate system for this embodiment) converts part of blue light emitted by the blue LED chip into green light. Within the range of 510nm to 580nm, by taking 5nm as a measuring interval, the maximum value of a relative percentile difference between two neighboring spectral intensities with the same wavelength broadband is 0.09. The red fluorophor (a nitride fluorescent powder for this embodiment) converts part of blue light emitted by the blue LED chip into red light, which forms a second peak in FIG. 4. For the second peak, a luminescent peak is at a wavelength of 635nm, and a half-width FWHM is 80.0±5nm. A peak intensity of the first peak is about 51.6% of that of the second peak. The distribution of $A(\lambda)$ in Embodiment 2 is illustrated in FIG. 5, wherein $A(\lambda)=A1(\lambda)-A2(\lambda)$, and as can be seen from the figure, a value of $A(\lambda)$ is in the range between -1.16 and 1.40. A color coordinate of Embodiment 2 is x=0.4438 and y=0.3835 (x=0.4438, y=0.3835), a color temperature is 2728K, color rendering indexes CRI=90.3, R9=80.9, Rf=91.6, and a gamut index Rg=107.2.

Embodiment 3

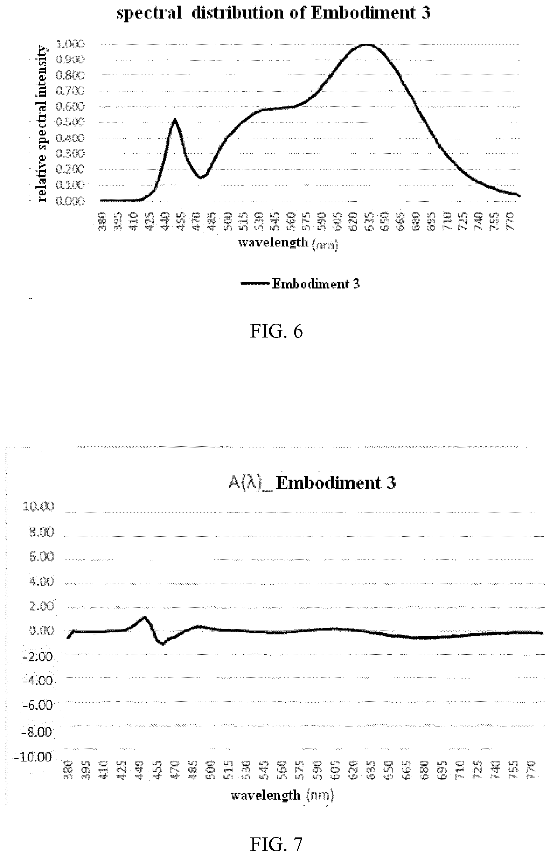

In the following, Embodiment 3 is described, which does not fall under the definition of independent claim 1. The light source module 104 is provided with: a blue LED chip with a peak wavelength of 450 ±5nm which is used as a blue light generating unit, a red fluorophor capable of converting part of blue light emitted by the blue light generating unit into red light which is used as a red light generating unit, and a green fluorophor capable of converting part of blue light emitted by the blue light generating unit into green light which is used as a green light generating unit. In the present embodiment, the blue light LED chip is used not only as the blue light generating unit, but also as an excitation light source for the red light generating unit and the green light generating unit. FIG. 6 is a schematic diagram illustrating the relative spectral energy distribution of Embodiment 3. A luminescent peak for forming a first peak in the figure by energy of blue light emitted by the blue light LED chip is at a wavelength of 450nm, and a half-width FWHM is 21.8±5nm. The green fluorophor (Lu-AG in aluminate system for this embodiment) converts part of blue light emitted by the blue LED chip into green light. Within the range of 510nm to 580nm, by taking 5nm as a measuring interval, the maximum value of a relative percentile difference between two neighboring spectral intensities with the same wavelength broadband is 0.08. The red fluorophor (a nitride fluorescent powder for this embodiment) converts part of blue light emitted by the blue LED chip into red light, which forms a second peak in FIG. 6. For the second peak, a luminescent peak is at a wavelength of 635nm, and a half-width FWHM is 80.6±5nm. A peak intensity of the first peak is about 52.1% of that of the second peak. The distribution of $A(\lambda)$ in Embodiment 3 is illustrated in FIG. 7, wherein $A(\lambda)=A1(\lambda)-A2(\lambda)$, and as can be seen from the figure, a value of $A(\lambda)$ is in the range between -1.11 and 1.15. A color coordinate of Embodiment 3 is x=0.4348 and y=0.4014 (x=0.4348, y=0.4014), a color temperature is 3014K, color rendering indexes CRI=96.6, R9=97.5, Rf=95.5, and a gamut index Rg=103.0.

Embodiment 4

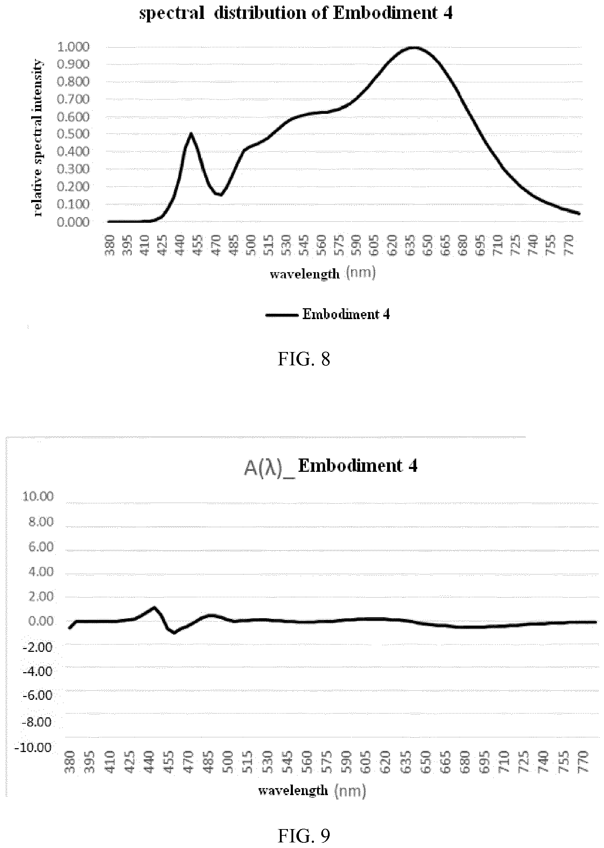

In the following, Embodiment 4 is described, which does not fall under the definition of independent claim 1. The light source module 104 is provided with: a blue LED chip with a peak wavelength of 450 ±5nm which is used as a blue light generating unit, a red fluorophor capable of converting part of blue light emitted by the blue light generating unit into red light which is used as a red light generating unit, and a green fluorophor capable of converting part of blue light emitted by the blue light generating unit into green light which is used as a green light generating unit. In the present embodiment, the blue light LED chip is used not only as the blue light generating unit, but also as an excitation light source for the red light generating unit and the green light generating unit. FIG. 8 is a schematic diagram illustrating the relative spectral energy distribution of Embodiment 4. A luminescent peak for forming a first peak in the figure by energy of blue light emitted by the blue light LED chip is at a wavelength of 450nm, and a half-width FWHM is 21.8±5nm. The green fluorophor (Ga-YAG in aluminate system for this embodiment) converts part of blue light emitted by the blue LED chip into green light. Within the range of 510nm to 580nm, by taking 5nm as a measuring interval, the maximum value of a relative percentile difference between two neighboring spectral intensities with the same wavelength broadband is 0.06. The red fluorophor (a nitride fluorescent powder for this embodiment) converts part of blue light emitted by the blue LED chip into red light, which forms a second peak in FIG. 8. For the second peak, a luminescent peak is at a wavelength of 640nm, and a half-width FWHM is 96.4±5nm. A peak intensity of the first peak is about 50.3% of that of the second peak. The distribution of $A(\lambda)$ in Embodiment 4 is illustrated in FIG. 9, wherein $A(\lambda)=A1(\lambda)-A2(\lambda)$, and as can be seen from the figure, a value of $A(\lambda)$ is in the range between -1.06 and 1.10. A color coordinate of Embodiment 4 is x=0.4325 and y=0.4045 (x=0.4325, y=0.4045), a color temperature is 3080K, color rendering indexes CRI=97.3, R9=97.0, Rf=95.5, and a gamut index Rg=103.0.

Embodiment 5

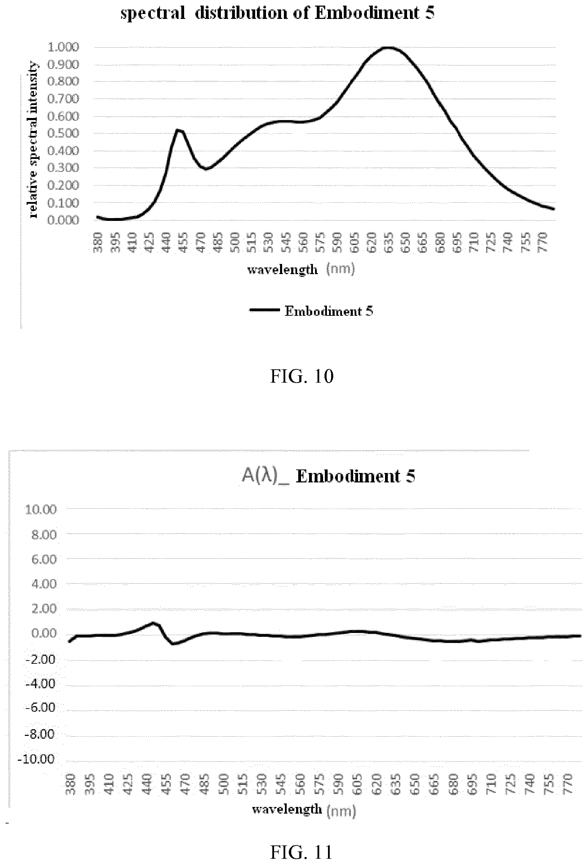

In the following, Embodiment 5 is described, which does not fall under the definition of independent claim 1. The light source module 104 is provided with: a blue LED chip with a peak wavelength of 450 ±5nm which is used as a blue light generating unit, a red fluorophor capable of converting part of blue light emitted by the blue light generating unit into red light which is used as a red light generating unit, and a green fluorophor capable of converting part of blue light emitted by the blue light generating unit into green light which is used as a green light generating unit. In the present embodiment, the blue light LED chip is used not only as the blue light generating unit, but also as an excitation light source for the red light generating unit and the green light generating unit. FIG. 10 is a schematic diagram illustrating the relative spectral energy distribution of Embodiment 5. A luminescent peak for forming a first peak in the figure by energy of blue light emitted by the blue light LED chip is at a wavelength of 450nm, and a half-width FWHM is 21.8±5nm. The green fluorophor converts part of blue light emitted by the blue LED chip into green light. Within the range of 510nm to 580nm, by taking 5nm as a measuring interval, the maximum value of a relative percentile difference between two neighboring spectral intensities with the same wavelength broadband is 0.06. The red fluorophor (a nitride fluorescent powder in this embodiment) converts part of blue light emitted by the blue LED chip into red light, which forms a second peak in FIG. 10. For the second peak, a luminescent peak is at a wavelength of 635nm, and a half-width FWHM is 80.0 ±5nm. A peak intensity of the first peak is about 52.1% of that of the second peak. The distribution of $A(\lambda)$ in Embodiment 5 is illustrated in FIG. 11, wherein $A(\lambda)=A1(\lambda)-A2(\lambda)$, and as can be seen from the figure, a value of $A(\lambda)$ is in the range between -0.71 and 0.93. A color coordinate of Embodiment 5 is x=0.4194 and y=0.3840, a color temperature is 3163K, color rendering indexes CRI=92.4, R9=78.9, Rf=93.8, and a gamut index Rg=104.8.

The light color of the light source module of the present invention is standard white, and its Duv is in the range between -5 and 5. FIG. 12 illustrates the light color coordinates of the light source modules 104 in Embodiments 1 to 5 in the CIE1931 color coordinate system, and it can be found that, these points all fall within such a coordinate scope that x is in the range between 0.410 and 0.450 and y is in the range between 0.375 and 0.415 (x=0.410~0.450, y=0.375~0.415). Further, it's found that, Embodiment 1, Embodiment 3 and Embodiment 4 achieve better effects, and the color coordinate scope of these three embodiments is that, x is in the range between 0.420 and 0.440, and y is in the range between 0.385 and 0.405 (x=0.420~0.440,y=0.385~0.405). Moreover, the best scope is that, x is in the range between 0.425 and 0.435, and y is in the range between 0.390 and 0.400 (x=0.425~0.435, y=0.390~0.400); Embodiment 1 is just within this best scope.

The objectives, the technical solutions and the beneficial advantages of the present invention have been described in details with reference to the above particular embodiments. It should be understood that the above are only specific implementations of the present disclosure, and the protection scope of the present disclosure is not limited thereto. The invention is defined by the appended claims.

**Claims**

1. A light source module (104), comprising

   a blue light generating unit (1041) configured to emit blue light;
   a green light generating unit (1042) configured to emit green light; and
   a red light generating unit (1043) configured to emit red light, wherein
   for the blue light emitted by the blue light generating unit (1041), a peak wavelength is within the range of 430nm to 470nm, and half the value of the full width at half maximum of the emission spectrum is within the range of 15nm to 35nm;
   for the red light emitted by the red light generating unit (1042), a peak wavelength is within the range of 620nm to 660nm, and half the value of the full width at half maximum of the emission spectrum is within the range of 70nm to 105nm; wherein a peak intensity of the blue light is 40% to 60% of a peak intensity of the red light;
   for the green light emitted by the green light generating unit (1043), within a spectrum range of 510nm to 580nm, by taking 5nm as a measuring interval, a relative difference of neighboring spectral intensities within a wavelength width of 5nm is less than 15%; and
   irradiation light emitted by the light source module (104) satisfies such a condition in the CIE1931 color coordinate system that, a horizontal coordinate X is within the range of 0.410 to 0.450, and a longitudinal coordinate Y is within the range of 0.375 to 0.415.

2. The light source module (104) according to claim 1, wherein half the value of the full width at half maximum of the emission spectrum of the red light is within the range of 70nm to 85nm or the range of 95nm to 105nm.

3. The light source module (104) according to claim 1, wherein the blue light generating unit (1041) is a blue LED chip,

   and/or wherein the green light generating unit (1042) contains a green fluorophor which absorbs light emitted by the blue light generating unit (1041) and emits green light through wavelength conversion,
   and/or the red light generating unit (1043) contains a red fluorophor which absorbs light emitted by the blue light generating unit (1041) and emits red light through wavelength conversion.

4. The light source module (104) according to claim 1, wherein the blue light generating unit (1041), the green light generating unit (1042) and the red light generating unit (1043) are integrally packaged, wherein

   the blue light generating unit (1041) is a blue LED,
   the green light generating unit (1042) is a green fluorophor which absorbs light emitted by the blue light generating unit (1041) and emits green light through wavelength conversion, and
   the red light generating unit (1043) is a red fluorophor which absorbs light emitted by the blue light generating unit (1041) and emits red light through wavelength conversion.

5. The light source module (104) according to claim 3 or 4, wherein the green fluorophor is of aluminate system or silicate system or nitride system or oxynitride system or a combination of any two thereof.

6. The light source module (104) according to claim 3 or 4, wherein the red fluorophor is of nitride system or silicate system or a combination thereof.

7. The light source module (104) according to claim 1, wherein, the horizontal coordinate X is within the range of 0.420 to 0.440, and the longitudinal coordinate Y is within the range of 0.385 to 0.405.

8. The light source module (104) according to claim 7, wherein the horizontal coordinate X is within the range of 0.425 to 0.435, and the longitudinal coordinate Y is within the range of 0.390 to 0.400.

9. The light source module (104) according to claim 1, wherein a color temperature of the light emitted by the light source module (104) is within the range of 2500K to 3600K,
   and/or a color rendering parameter CRI of the light emitted by the light source module (104) is greater than 90.

10. The light source module (104) according to claim 1, wherein a color rendering index Rf of the light emitted by the light source module (104) is greater than 90.

11. The light source module (104) according to claim 1, wherein a color rendering index R9 of the light emitted by the light source module (104) is greater than 70,
and/or a gamut index Rg of the light emitted by the light source module (104) is greater than 100.

12. An illuminating device, comprising

the light source module (104) according to any one of claims 1 to 11; and
a power supply module connected to the light source module (104) and configured to provide the light source module (104) with a working power.

13. The illuminating device according to claim 12, further comprising a controller (102), the controller (102) is connected to the light source module (104) and configured to adjust the irradiation light emitted by the light source module (104).

**Patentansprüche**

1. Lichtquellenmodul (104) mit:

einer blaues Licht erzeugenden Einheit (1041), die zum Emittieren von blauem Licht ausgebildet ist;
einer grünes Licht erzeugenden Einheit (1042), die zum Emittieren von grünem Licht ausgebildet ist; und
einer rotes Licht erzeugenden Einheit (1043), die zum Emittieren von rotem Licht ausgebildet ist, wobei
für das von der blaues Licht erzeugenden Einheit (1041) emittierte blaue Licht eine Spitzenwellenlänge im Bereich von 430 nm bis 470 nm liegt, und der Halbwert der vollen Breite bei halbem Maximum des Emissionsspektrums im Bereich von 15 nm bis 35 nm liegt;
für das von der rotes Licht erzeugenden Einheit (1042) emittierte rote Licht eine Spitzenwellenlänge im Bereich von 620 nm bis 660 nm liegt, und der Halbwert der vollen Breite bei halbem Maximum des Emissionsspektrums im Bereich von 70 nm bis 105 nm liegt; wobei die Spitzenintensität des blauen Lichts 40% bis 60% einer Spitzenintensität des roten Lichts beträgt;
für das von der grünes Licht erzeugenden Einheit (1043) emittierte grüne Licht, innerhalb eines Spektralbereichs von 510 nm bis 580 nm, unter Verwendung von 5 nm als ein Messintervall, eine relative Differenz benachbarter spektraler Intensitäten innerhalb einer Wellenlängenbreite von 5 nm weniger als 15% beträgt; und
von dem Lichtquellenmodul (104) emittiertes Bestrahlungslicht erfüllt eine Bedingung des CIE1931 Farbkoordinatensystems, dass eine horizontale Koordinate X im Bereich von 0,410 bis 0,450 und eine Längskoordinate Y im Bereich von 0,375 bis 0,415 liegt.

2. Lichtquellenmodul (104) nach Anspruch 1, bei welchem die Hälfte des Werts der vollen Breite bei halbem Maximum des Emissionsspektrums des roten Lichts im Bereich von 70 nm bis 85 nm oder im Bereich von 95 bis 105 nm liegt.

3. Lichtquellenmodul (104) nach Anspruch 1, bei welchem die blaues Licht erzeugende Einheit (1041) ein blauer LED-Chip ist,

und/oder wobei die grünes Licht erzeugende Einheit (1042) ein grünes Fluorophor enthält, das von der blaues Licht erzeugenden Einheit (1041) emittiertes Licht absorbiert und grünes Licht durch Wellenlängenumwandlung emittiert,
und/oder die rotes Licht erzeugende Einheit (1043) ein rotes Fluorophor enthält, das von der blaues Licht erzeugenden Einheit (1041) emittiertes Licht absorbiert und rotes Licht durch Wellenlängenumwandlung emittiert.

4. Lichtquellenmodul (104) nach Anspruch 1, bei welchem die blaues Licht erzeugende Einheit (1041), die grünes Licht erzeugende Einheit (1042) und die rotes Licht erzeugende Einheit (1043) einstückig verpackt sind, wobei

die blaues Licht erzeugende Einheit (1041) eine blaue LED ist,
die grünes Licht erzeugende Einheit (1042) ein grünes Fluorophor ist, das von der blaues Licht erzeugenden Einheit (1041) emittiertes Licht absorbiert und grünes Licht durch Wellenlängenumwandlung emittiert, und die rotes Licht erzeugende Einheit (1043) ein rotes Fluorophor ist, das von der blaues Licht erzeugenden Einheit (1041) emittiertes Licht absorbiert und rotes Licht durch Wellenlängenumwandlung emittiert.

5. Lichtquellenmodul (104) nach Anspruch 3 oder 4, bei welchem das grüne Fluorophor ein Aluminatsystem oder ein Silikatsystem oder ein Nitridsystem oder ein Oxynitridsystem oder eine Kombination zweier beliebiger der genannten Systeme ist.

**6.** Lichtquellenmodul (104) nach Anspruch 3 oder 4, bei welchem das rote Fluorophor ein Nitridsystem oder ein Silikatsystem oder eine Kombination derselben ist.

**7.** Lichtquellenmodul (104) nach Anspruch 1, bei welchem die horizontale Koordinate X im Bereich von 0,420 bis 0,440 und die Längskoordinate Y im Bereich von 0,385 bis 0,405 liegt.

**8.** Lichtquellenmodul (104) nach Anspruch 7, bei welchem die horizontale Koordinate X im Bereich von 0,425 bis 0,435 und die Längskoordinate Y im Bereich von 0,390 bis 0,400 liegt.

**9.** Lichtquellenmodul (104) nach Anspruch 1, bei welchem eine Farbtemperatur des von dem Lichtquellenmodul (104) emittierten Lichts im Bereich von 2500K bis 3600K liegt,
und/oder ein Farbwiedergabeparameter CRI des von dem Lichtquellenmodul (104) emittierten Lichts größer als 90 ist.

**10.** Lichtquellenmodul (104) nach Anspruch 1, bei welchem ein Farbwiedergabeindex Rf des von dem Lichtquellenmodul (104) emittierten Lichts größer als 90 ist.

**11.** Lichtquellenmodul (104) nach Anspruch 1, bei welchem ein Farbwiedergabeindex R9 des von dem Lichtquellenmodul (104) emittierten Lichts größer als 70 ist,
und/oder ein Gamutindex Rg des von dem Lichtquellenmodul (104) emittierten Lichts größer als 100 ist.

**12.** Beleuchtungsvorrichtung mit

dem Lichtquellenmodul (104) nach einem der Ansprüche 1 bis 11, und
einem Energieversorgungsmodul, das mit dem Lichtquellenmodul (104) verbunden ist und dazu ausgebildet ist, dem Lichtquellenmodul (104) einen Arbeitsstrom bereitzustellen.

**13.** Beleuchtungsvorrichtung nach Anspruch 12, ferner mit einer Steuerung (102), wobei die Steuerung (102) mit dem Lichtquellenmodul (104) verbunden ist und dazu ausgebildet ist, das von dem Lichtquellenmodul (104) emittierte Bestrahlungslicht einzustellen.

**Revendications**

**1.** Module source de lumière (104), comprenant

une unité de génération de lumière bleue (1041) configurée pour émettre de la lumière bleue ;
une unité de génération de lumière verte (1042) configurée pour émettre de la lumière verte ; et
une unité de génération de lumière rouge (1043) configurée pour émettre de la lumière rouge, dans lequel
pour la lumière bleue émise par l'unité de génération de lumière bleue (1041), une longueur d'onde de crête se situe dans la plage de 430 nm à 470 nm, et la moitié de la valeur de la pleine largeur à mi-hauteur du spectre d'émission se situe dans la plage de 15 nm à 35 nm ;
pour la lumière rouge émise par l'unité de génération de lumière rouge (1042), une longueur d'onde de crête se situe dans la plage de 620 nm à 660 nm, et la moitié de la valeur de la pleine largeur à mi-hauteur du spectre d'émission se situe dans la plage de 70 nm à 105 nm ; dans lequel une intensité de crête de la lumière bleue va de 40 % à 60 % d'une intensité de crête de la lumière rouge ;
pour la lumière verte émise par l'unité de génération de lumière verte (1043), dans une plage spectrale de 510 nm à 580 nm, en prenant 5 nm comme intervalle de mesure, une différence relative d'intensités spectrales voisines dans une largeur de longueur d'onde de 5 nm est inférieure à 15 % ; et
la lumière d'irradiation émise par le module source de lumière (104) satisfait une condition telle dans le système de coordonnées de couleurs CIE1931 qu'une coordonnée horizontale X se situe dans la plage de 0,410 à 0,450, et une coordonnée longitudinale Y se situe dans la plage de 0,375 à 0,415.

**2.** Module source de lumière (104) selon la revendication 1, dans lequel la moitié de la valeur de la pleine largeur à mi-hauteur du spectre d'émission de la lumière rouge se situe dans la plage de 70 nm à 85 nm ou dans la plage de 95 nm à 105 nm.

**3.** Module source de lumière (104) selon la revendication 1, dans lequel l'unité de génération de lumière bleue (1041) est une puce de DEL bleue,

et/ou dans lequel l'unité de génération de lumière verte (1042) contient un fluorophore vert qui absorbe la lumière émise par l'unité de génération de lumière bleue (1041) et émet de la lumière verte par conversion de longueur d'onde,
et/ou l'unité de génération de lumière rouge (1043) contient un fluorophore rouge qui absorbe la lumière émise par l'unité de génération de lumière bleue (1041) et émet de la lumière rouge par conversion de longueur d'onde.

**4.** Module source de lumière (104) selon la revendication 1, dans lequel l'unité de génération de lumière bleue (1041), l'unité de génération de lumière verte (1042) et l'unité de génération de lumière rouge (1043) sont emballées intégralement, dans lequel

l'unité de génération de lumière bleue (1041) est une DEL bleue,
l'unité de génération de lumière verte (1042) est un fluorophore vert qui absorbe la lumière émise par l'unité de génération de lumière bleue (1041) et émet de la lumière verte par conversion de longueur d'onde, et
l'unité de génération de lumière rouge (1043) est un fluorophore rouge qui absorbe la lumière émise par l'unité de génération de lumière bleue (1041) et émet de la lumière rouge par conversion de longueur d'onde.

**5.** Module source de lumière (104) selon la revendication 3 ou 4, dans lequel le fluorophore vert provient d'un système d'aluminate ou d'un système de silicate ou d'un système de nitrure ou d'un système d'oxynitrure ou d'une combinaison de deux quelconques de ceux-ci.

**6.** Module source de lumière (104) selon la revendication 3 ou 4, dans lequel le fluorophore rouge provient d'un système de nitrure ou d'un système de silicate ou d'une combinaison de ceux-ci.

**7.** Module source de lumière (104) selon la revendication 1, dans lequel la coordonnée horizontale X se situe dans la plage de 0,420 à 0,440, et la coordonnée longitudinale Y se situe dans la plage de 0,385 à 0,405.

**8.** Module source de lumière (104) selon la revendication 7, dans lequel la coordonnée horizontale X se situe dans la plage de 0,425 à 0,435, et la coordonnée longitudinale Y se situe dans la plage de 0,390 à 0,400.

**9.** Module source de lumière (104) selon la revendication 1, dans lequel une température de couleur de la lumière émise par le module source de lumière (104) se situe dans la plage de 2 500 K à 3 600 K,
et/ou un paramètre de rendu des couleurs CRI de la lumière émise par le module source de lumière (104) est supérieur à 90.

**10.** Module source de lumière (104) selon la revendication 1, dans lequel un indice de rendu des couleurs Rf de la lumière émise par le module source de lumière (104) est supérieur à 90.

**11.** Module source de lumière (104) selon la revendication 1, dans lequel un indice de rendu des couleurs R9 de la lumière émise par le module source de lumière (104) est supérieur à 70,
et/ou un indice de gamme Rg de la lumière émise par le module source de lumière (104) est supérieur à 100.

**12.** Dispositif d'éclairage, comprenant

le module source de lumière (104) selon l'une quelconque des revendications 1 à 11 ; et
un module d'alimentation connecté au module source de lumière (104) et configuré pour fournir au module source de lumière (104) une puissance de travail.

**13.** Dispositif d'éclairage selon la revendication 12, comprenant en outre un dispositif de commande (102), le dispositif de commande (102) est connecté au module source de lumière (104) et configuré pour ajuster la lumière d'irradiation émise par le module source de lumière (104).

FIG. 1

## spectral distribution of Embodiment 1

— Embodiment 1

FIG. 2

## A(λ)_ Embodiment 1

FIG. 3

## spectral distribution of Embodiment 2

FIG. 4

## A(λ)_ Embodiment 2

FIG. 5

## spectral distribution of Embodiment 3

FIG. 6

## A(λ)_ Embodiment 3

FIG. 7

## spectral distribution of Embodiment 4

FIG. 8

## A(λ)_ Embodiment 4

FIG. 9

## spectral distribution of Embodiment 5

FIG. 10

## A(λ)_ Embodiment 5

FIG. 11

FIG. 12

FIG. 13

**EP 3 575 670 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2642519 A2
- US 2015049459 A1
- EP 2432037 A1
- US 8643038 B2